# EUROPEAN PATENT APPLICATION

(11) **EP 3 151 064 A2**
(43) Date of publication of application: **05.04.2017**
(21) Application number: 16189155.1
(22) Date of filing: 16.09.2016
(51) Int. Cl.: G03F 1/62

(54) **EUV PELLICLE FILM AND MANUFACTURING METHOD THEREOF**

(30) Priority: 30.09.2015 US 201562234702 P; 29.03.2016 US 201615083304
(71) Applicant: G-Force Nanotechnology Ltd., Taichung 40456 (TW)
(72) Inventor: Chiu, Jen-Kuan, Taichung 40456 (TW); Yeh, Chao-Hui, Taichung 40456 (TW)
(74) Representative: Becker Kurig Straus

(57) **Abstract**

Provided is a pellicle film used for protecting an EUV lithographic mask including a first layer, a second layer, and a layered material. The second layer is formed on the first layer. The layered material is formed between the first layer and the second layer. The material of the layered material includes graphene, boron nitride, transition metal dichalcogenide, or a combination thereof.

## Description

### BACKGROUND OF THE INVENTION

### Field of the Invention

The invention relates to a pellicle film and a manufacturing method thereof, and more particularly to an EUV pellicle film for protecting an EUV lithographic mask and a manufacturing method thereof.

### Description of Related Art

As technology advances, the density of the semiconductor device has become higher. In response to a new generation of patterning processes, the EUV lithography technique adopting EUV light having short wavelength has become the mainstream of the future. In the EUV lithography technique, a pellicle film is generally provided to the EUV lithographic mask to prevent dust or particles from attaching to the EUV lithographic mask and causing the failure of patterning process.

Basically, EUV light is readily absorbed by all substances. From the perspective of reducing EUV light absorption, a silicon thin film is generally used as the pellicle film. However, the thermal conductivity and the mechanical strength of nano-size silicon thin film are poor. When EUV lithography is performed, the silicon thin film is readily cracked from heat, such that the life time of the silicon thin film is too short and manufacturing costs are increased.

### SUMMARY OF THE INVENTION

The invention provides an EUV pellicle film and a manufacturing method thereof having better thermal conductivity, mechanical strength, and toughness. As a result, life time is increased and manufacturing costs are reduced.

The invention provides a pellicle film used for protecting an EUV lithographic mask including a first layer, a second layer, and a layered material. The second layer is formed on the first layer. The layered material is formed between the first layer and the second layer. The material of the layered material includes graphene, boron nitride, transition metal dichalcogenide, or a combination thereof.

In an embodiment of the invention, the material of the first layer and the material of the second layer respectively include silicon (Si), silicon oxide (SiO), silicon nitride (SiN), silicon carbide (SiC), ruthenium (Ru), lanthanum (La), molybdenum (Mo), or a combination thereof.

In an embodiment of the invention, the material of the first layer and the material of the second layer are the same.

In an embodiment of the invention, the material of the first layer and the material of the second layer are different.

In an embodiment of the invention, the layered material includes a single-layer structure, a two-layer structure, or a multilayer structure.

In an embodiment of the invention, the layered material is directly formed on the first layer.

In an embodiment of the invention, the surface of the layered material is wrinkle-free or crack-free.

In an embodiment of the invention, the layered material is bonded to the first layer.

In an embodiment of the invention, the layered material is grown via van der Waals epitaxy.

In an embodiment of the invention, the layers in the layered material are separated from one another by a van der Waals distance.

In an embodiment of the invention, the layered material has a uniform surface.

In an embodiment of the invention, the surface roughness of the layered material is less than 6 nm.

The invention provides a manufacturing method of an EUV pellicle film used for protecting an EUV lithographic mask, including the following steps. A substrate is provided. A liner layer is formed on the front side of the substrate. A layered material is grown on the liner layer. A portion of the back side of the substrate is selectively removed to expose the back side of the liner layer, such that the layered material and the liner layer are suspended.

In an embodiment of the invention, the material of the substrate includes silicon, glass, or a combination thereof.

In an embodiment of the invention, the material of the liner layer includes silicon (Si), silicon oxide (SiO), silicon nitride (SiN), silicon carbide (SiC), ruthenium (Ru), lanthanum (La), molybdenum (Mo), or a combination thereof.

In an embodiment of the invention, the material of the layered material includes graphene, boron nitride, transition metal dichalcogenide, or a combination thereof.

In an embodiment of the invention, the layered material includes a single-layer structure, a two-layer structure, or a multilayer structure.

In an embodiment of the invention, the layered material is directly grown on the liner layer via chemical vapor deposition.

In an embodiment of the invention, the layered material is grown on the liner layer via plasma-enhanced chemical vapor deposition without a metal catalyst.

In an embodiment of the invention, the plasma-enhanced chemical vapor deposition further includes UV irradiation.

In an embodiment of the invention, the reactant gas used in the plasma-enhanced chemical vapor deposition includes methane, acetylene, acetone, toluene, or a combination thereof.

In an embodiment of the invention, the reactant gas used in the plasma-enhanced chemical vapor deposition includes at least one oxygen-containing organic compound.

In an embodiment of the invention, the layered material is grown in a temperature range of 900 °C to 1100 °C.

In an embodiment of the invention, the layered material and the liner layer are connected via chemical bonding.

In an embodiment of the invention, the thickness of the layered material is between 1 nm and 35 nm.

In an embodiment of the invention, the manufacturing method further includes forming a cap layer on the layered material.

In an embodiment of the invention, the material of the cap layer includes silicon (Si), silicon oxide (SiO), silicon nitride (SiN), silicon carbide (SiC), ruthenium (Ru), lanthanum (La), molybdenum (Mo), or a combination thereof.

In an embodiment of the invention, the method of selectively removing a portion of the back side of the substrate includes reactive ion etching (RIE).

In an embodiment of the invention, the manufacturing method further includes removing a portion of the liner layer to expose the back side of the layered material.

In an embodiment of the invention, the front side of the liner layer is further treated with hydrogen gas before the layered material is formed.

Based on the above, in the invention, by directly growing the layered material on the liner layer via chemical vapor deposition, the surface of the formed layered material is smooth and wrinkle-free or crack-free. Therefore, the layered material of the invention has better mechanical strength and toughness. Moreover, in comparison to a conventional silicon thin film, the layered material of the invention has better thermal conductivity, and thermal cracking does not readily occur thereto, such that life time can be increased and manufacturing costs can be reduced.

In order to make the aforementioned features and advantages of the disclosure more comprehensible, embodiments accompanied with figures are described in detail below.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIGs. 1A to 1B illustrate schematics of a manufacturing process of a pellicle film of the first embodiment of the invention.
FIG. 2 illustrates a cross-sectional schematic of a pellicle film of the second embodiment of the invention.
FIG. 3A shows an atomic force microscopy topography of the layered material grown directly on the liner layer in an exemplary embodiment of the invention.
FIG. 3B shows the height profile of the layered material of Fig. 3A.
FIG. 4 shows a cross-sectional transmission electron microscopy image of the pellicle film on the substrate in an exemplary embodiment of the invention.
FIG. 5 shows the Raman spectrum of the pellicle film on the substrate in an exemplary embodiment of the invention.

### DESCRIPTION OF THE EMBODIMENTS

The invention is more comprehensively described with reference to the figures of the present embodiments. However, the invention can also be implemented in various different forms, and is not limited to the embodiments in the present specification. The thickness of the layers and regions in the figures is enlarged for clarity. The same or similar reference numerals represent the same or similar elements and are not repeated in the following paragraphs. Moreover, in the present specification, the EUV light refers to light having a wavelength between 5 nm and 30 nm.

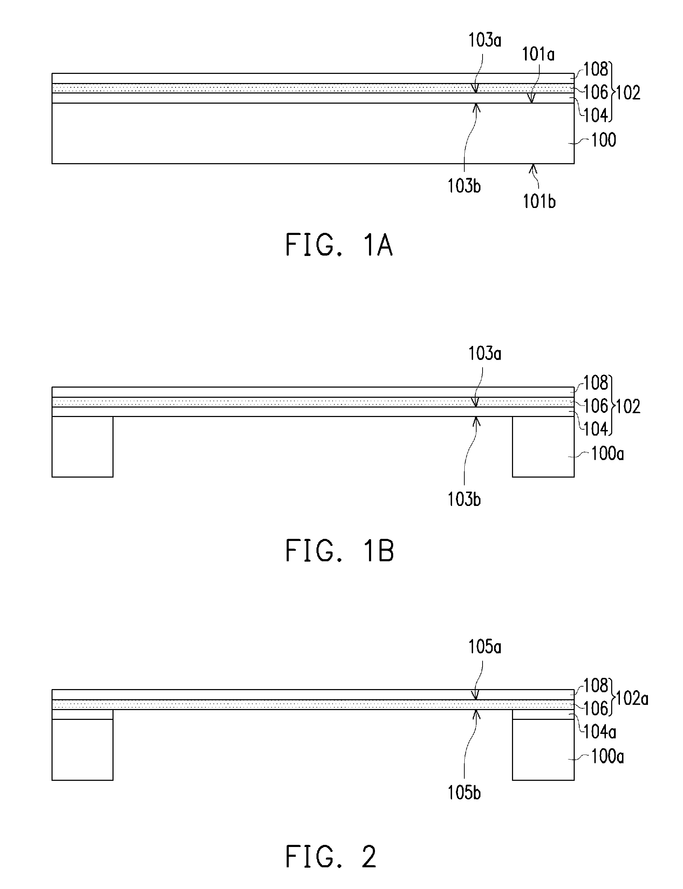

FIG. 1A to FIG. 1B are schematics illustrating a manufacturing process of a pellicle film of the first embodiment of the invention.

Referring to FIG. 1A, a substrate 100 is provided. The substrate 100 has a front side 101a and a back side 101b opposite to each other. In an embodiment, the material of the substrate 100 can be, for instance, silicon, glass, or a combination thereof. However, the invention is not limited thereto, and in other embodiments, the substrate 100 can also be, for instance, a sapphire substrate or a silicon carbide substrate.

Then, a liner layer 104, a layered material 106, and a cap layer 108 are formed on the front side 101a of the substrate 100 in order. In an embodiment, the material of the liner layer 104 and the material of the cap layer 108 can respectively be, for instance, silicon (Si), silicon oxide (SiO), silicon nitride (SiN), silicon carbide (SiC), ruthenium (Ru), lanthanum (La), molybdenum (Mo), or a combination thereof. The material of the liner layer 104 and the material of the cap layer 108 can be the same and can also be different, and the invention is not limited thereto. The forming method of the liner layer 104 and the cap layer 108 can be physical vapor deposition or chemical vapor deposition. Although FIG. 1A shows the cap layer 108 is formed on the layered material 106, the invention is not limited thereto. In other embodiments, the cap layer 108 can also not be formed on the layered material 106.

In an embodiment, the material of the layered material 106 can be, for instance, graphene, boron nitride, transition metal dichalcogenide, or a combination thereof. In comparison to a conventional silicon thin film, the layered material 106 of the present embodiment has better thermal conductivity, mechanical strength, and toughness. Moreover, the layered material 106 of the present embodiment has low absorbance for EUV light. For example, a single-layer graphene has a transmittance of 99.7% - 99.8% of the incident EUV light.

It should be mentioned that, the forming method of the layered material 106 can include, for instance, directly growing the layered material 106 on the liner layer 104 via chemical vapor deposition. A gas containing carbon and oxygen, usually together with a hydrogen gas as a catalytic gas and an inert gas as a diluting gas, is formed a reactant gas. The carbon source in the reactant gas can be, for instance, methane, acetylene, acetone, toluene, or a combination thereof. Specifically, in the chemical vapor deposition, UV light can be provided by a UV source to irradiate the reactant gas. The carbon source in the reactant gas is decomposed from the irradiation and the heating of the UV light, and the layered material 106 is formed via the deposition of carbon atoms released from the decomposition on the surface of the liner layer 104.

In an embodiment, the carbon source in the reactant gas can include at least one oxygen-containing organic compound. The carbon source in the reactant gas may be selected from at least one organic compound having at least one oxygen atom, including ketone, alcohol, ether, aldehyde, ester, phenol, and organic acid, or a combination thereof. The process temperature of the chemical vapor deposition can be between 900 °C and 1100 °C. In an embodiment, the chemical vapor deposition can be, for instance, plasma-enhanced chemical vapor deposition (PECVD) without a metal catalyst.

From the macroscopic perspective, the surface of the layered material 106 formed via the chemical vapor deposition is smooth and is wrinkle-free or crack-free. Therefore, the layered material 106 of the present embodiment has better mechanical strength and toughness. In an embodiment, the surface roughness of the layered material 106 can be less than 6 nm.

From the microscopic perspective, a layered material 106 having a single-layer structure, a two-layer structure, or a multilayer structure can be formed via the chemical vapor deposition. The layered material 106 and the liner layer 104 are connected via chemical bonding. The layers in the layered material 106 are separated from one another by a van der Waals distance. Therefore, water vapor is not accumulated between the layers in the layered material 106, and peeling is prevented as a result. Moreover, a delamination phenomenon is also not readily generated between the layered material 106 and the liner layer 104. Moreover, in the chemical vapor deposition of the present embodiment, process parameters can be adjusted to control the thickness of the layered material 106. In an embodiment, the thickness of the layered material 106 can be between 1 nm and 35 nm.

In another embodiment, the layered material 106 can also be grown on the liner layer 104 via van der Waals epitaxy. In the van der Waals epitaxy, a pre-deposited two-dimensional layered material such as graphene or boron nitride is served as an epitaxy layer on which other layered materials are grown.

Moreover, before the layered material 106 is formed, a front side 103a of the liner layer 104 can also be treated with hydrogen gas. The hydrogen gas treatment can clear native oxide of the front side 103a of the liner layer 104 such that the layered material 106 is directly formed on the front side 103a of the liner layer 104 without the unwanted oxide layer generated on the liner layer 104. In other words, the layered material 106 can be in direct contact with the liner layer 104. However, the invention is not limited thereto, and in another embodiment, the hydrogen gas treatment can also not be performed, such that a thin oxide layer exists between the layered material 106 and the liner layer 104. In this case, the growth rate of layer material 106 can be increased although the EUV transmission might be a bit sacrificed due to the existence of the thin oxide layer.

Referring to FIG. 1A and FIG. 1B, a portion of the back side 101b of the substrate 100 is selectively removed to expose a back side 103b of the liner layer 104, such that the cap layer 108, the layered material 106, and the liner layer 104 are suspended. At this point, the remaining substrate 100a can be regarded as a frame capable of supporting the pellicle film 102 formed by the cap layer 108, the layered material 106, and the liner layer 104. The pellicle film 102 can be disposed on the EUV lithographic mask to prevent dust or particles from attaching to the EUV lithographic mask. In an embodiment, a method of selectively removing the substrate 100 includes dry etching. The dry etching can be, for instance, reactive ion etching (RIE).

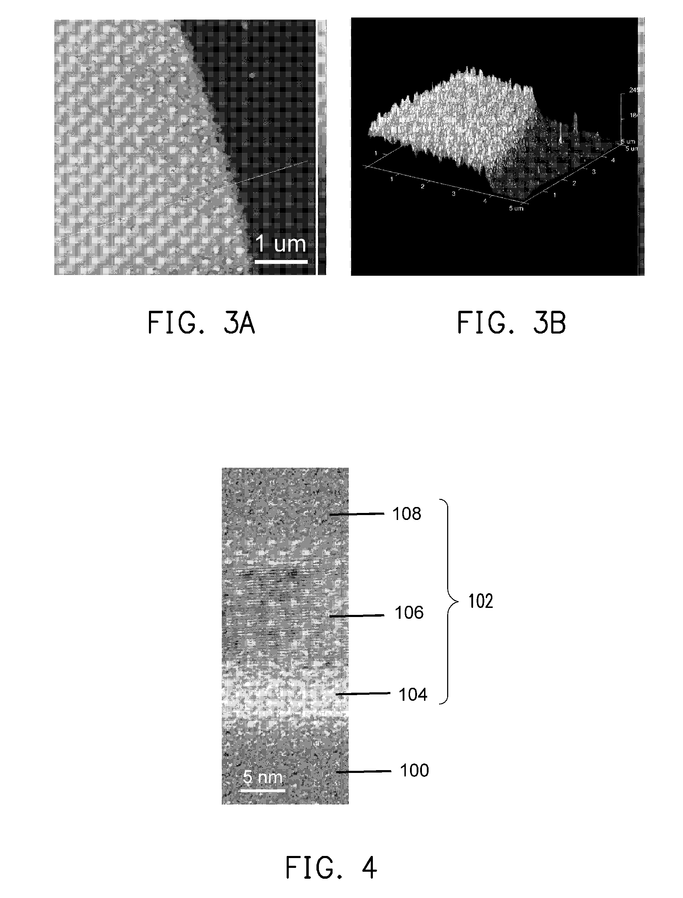

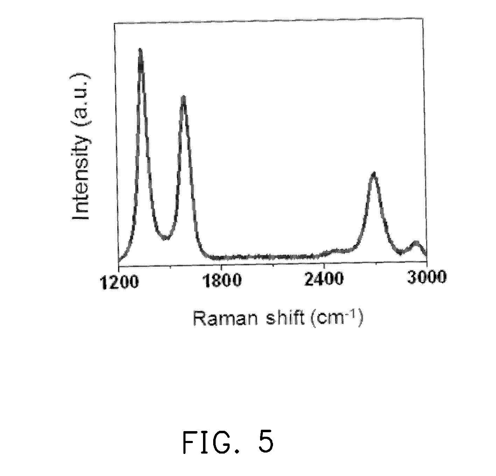

In order to further explain this invention, the steps of forming the layered material 106 of an exemplary embodiment, such as multilayer graphene, are as follows, which are however not intended to restrict the scope of this invention. The multilayer graphene was grown directly on the liner layer 104 at 1000 °C using PECVD. The deposition setting particularly includes a UV light source providing a continuous wavelength ranging from 160 nm to 400 nm. The UV source is located near the upstream of gas flow and the UV light irradiates in a direction parallel to the planar direction of the substrates. Ethyl methyl ether was used as the source of carbon and oxygen, with a constant flow rate of 30 sccm throughout the growth stage. Hydrogen gas was introduced as a catalytic gas with a flow rate of 120 sccm. Argon acted as a diluent gas with a flow rate of 200 sccm. High-quality multilayer graphene can be formed directly on the liner layer 104, followed by the deposition of a cap layer 108 on the multilayer graphene. FIG. 3A shows the atomic force microscopy topography of a layered material 106 (i.e., multilayer graphene) grown directly on liner layer 104 (i.e., silicon oxide) using the technique disclosed in this embodiment, while FIG. 3B shows the height profile of multilayer graphene. FIG. 4 shows a cross-sectional transmission electron microscopy image of the pellicle film 102 on the substrate 100, with the multilayer graphene grown using the technique disclosed in this embodiment. The pellicle film 102 consists of a layered material 106 (i.e., multilayer graphene) grown directly on liner layer 104 (i.e., silicon oxide) and a cap layer 108 (i.e., silicon nitride). The corresponding Raman spectrum, as shown in FIG. 5, exhibits a sharp G peak, indicating decent quality in crystallinity.

Referring to FIG. 2 after FIG. 1B, after a portion of the back side 101b of the substrate 100 is selectively removed, a portion of the liner layer 104 can also be removed to expose a back side 105b of the layered material 106. At this point, only the cap layer 108 and the layered material 106 are suspended to form another pellicle film 102a.

Based on the above, in the invention, by directly growing the layered material on the liner layer via chemical vapor deposition, the surface of the formed layered material is smooth and wrinkle-free or crack-free. Therefore, the layered material of the invention has better mechanical strength and toughness. Moreover, in comparison to a known silicon thin film, the layered material of the invention has better thermal conductivity, and thermal cracking does not readily occur thereto, such that life time can be increased and manufacturing costs can be reduced.

## Claims

1. A pellicle film (102) used for protecting an EUV lithographic mask, the pellicle film (102) comprising:
a first layer (104);
a second layer (108) formed on the first layer (104); and
a layered material (106) formed between the first layer (104) and the second layer (108), wherein a material of the layered material (106) comprises graphene, boron nitride, transition metal dichalcogenide, or a combination thereof.

2. The pellicle film (102) of claim 1, wherein a material of the first layer (104) and a material of the second layer (108) respectively comprise silicon (Si), silicon oxide (SiO), silicon nitride (SiN), silicon carbide (SiC), ruthenium (Ru), lanthanum (La), molybdenum (Mo), or a combination thereof.

3. The pellicle film (102) of claim 1, wherein the layered material (106) comprises a single-layer structure, a two-layer structure, or a multilayer structure.

4. The pellicle film (102) of claim 1, wherein the layered material (106) is directly grown on the first layer (104).

5. The pellicle film (102) of claim 1, wherein a surface of the layered material (106) is wrinkle-free or crack-free.

6. The pellicle film (102) of claim 1, wherein the layered material (106) is bonded to the first layer (104).

7. The pellicle film (102) of claim 1, wherein the layered material (106) is grown via van der Waals epitaxy.

8. The pellicle film (102) of claim 1, wherein layers in the layered material (106) are separated from one another by a van der Waals distance.

9. A manufacturing method of an EUV pellicle film (102, 102a) used for protecting an EUV lithographic mask, comprising:
providing a substrate (100);
forming a liner layer (104) on a front side of the substrate (100);
growing a layered material (106) on the liner layer (104); and
selectively removing a portion of a back side of the substrate (100) to expose a back side of the liner layer (104), such that the layered material (106) and the liner layer (104) are suspended.

10. The method of claim 9, wherein a material of the substrate (100) comprises silicon, glass, or a combination thereof.

11. The method of claim 9, wherein a material of the liner layer (104) comprises Si, SiO, SiN, SiC, Ru, La, Mo, or a combination thereof.

12. The method of claim 9, wherein a material of the layered material (106) comprises graphene, boron nitride, transition metal dichalcogenide, or a combination thereof.

13. The method of claim 9, wherein the layered material (106) comprises a single-layer structure, a two-layer structure, or a multilayer structure.

14. The method of claim 9, wherein the layered material (106) is directly grown on the liner layer (104) via chemical vapor deposition.

15. The method of claim 9, wherein the layered material (106) is grown on the liner layer (104) via a plasma-enhanced chemical vapor deposition without a metal catalyst.

16. The method of claim 15, wherein the plasma-enhanced chemical vapor deposition further comprises UV irradiation.

17. The method of claim 15, wherein a reactant gas used in the plasma-enhanced chemical vapor deposition comprises methane, acetylene, acetone, toluene, or a combination thereof.

18. The method of claim 15, wherein a reactant gas used in the plasma-enhanced chemical vapor deposition comprises at least one oxygen-containing organic compound.

19. The method of claim 15, wherein the layered material (106) is grown in a temperature range of 900 °C to 1100 °C.

20. The method of claim 9, wherein the layered material (106) and the liner layer (104) are connected via chemical bonding.

21. The method of claim 9, wherein a thickness of the layered material (106) is between 1 nm and 35 nm.

22. The method of claim 9, further comprising forming a cap layer (108) on the layered material (106).

23. The method of claim 22, wherein a material of the cap layer (108) comprises Si, SiO, SiN, SiC, Ru, La, Mo, or a combination thereof.

24. The method of claim 22, further comprising removing a portion of the liner layer (104) to expose a back side of the layered material (106).

25. The method of claim 9, further comprising treating a front side of the liner layer (104) with hydrogen gas before the layered material (106) is formed.
